# EUROPEAN PATENT SPECIFICATION

(11) **EP 2 100 702 B1**
(45) Date of publication and mention of the grant of the patent: **22.09.2010**
(21) Application number: 09003493.5
(22) Date of filing: 10.03.2009
(51) Int. Cl.: B27C 5/00, H05K 7/20

(54) **Electrical power tools**
Elektrische Werkzeuge
Outils d'alimentation électrique

(30) Priority: 12.03.2008 JP 2008062468
(43) Date of publication of application: 16.09.2009
(73) Proprietor: Makita Corporation, Anjo-shi, Aichi-ken (JP)
(72) Inventor: Nishimiya, Takeshi, Anjo-shi Aichi-ken (JP); Matsunaga, Yutaka, Anjo-shi Aichi-ken (JP)
(74) Representative: Kramer - Barske - Schmidtchen

(56) References cited:
- EP-A- 1 638 398
- DE-C1- 3 700 349
- JP-A- 11 077 608
- JP-A- 2007 283 447
- US-A1- 2004 070 946
- US-B1- 6 704 202

## Description

The present invention relates to electrical power tools. More particularly, the present invention relates to electrical power tools in which output power of a motor can be controlled by switching devices.

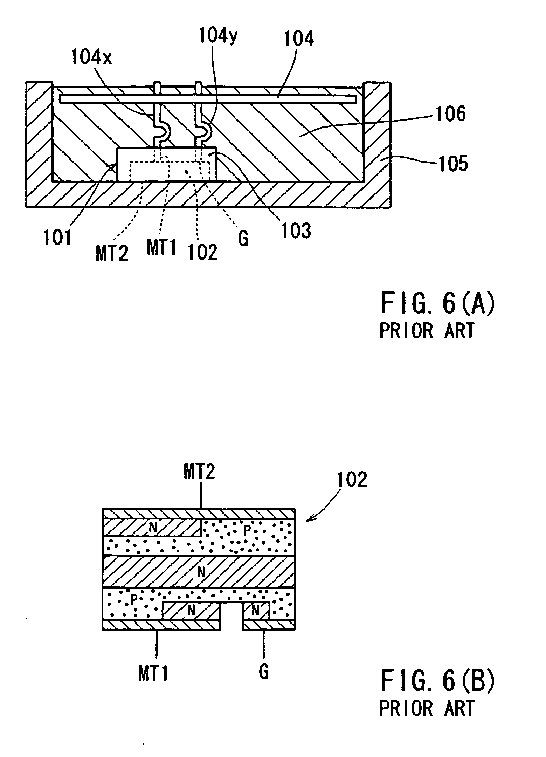

For example, a router (an electrical power tool) having a switching device is already known. As shown in FIG. 6(A), in the router, a triac (bidirectional thyristor) 101 is used as the switching device. The triac 101 can control currents supplied to a motor, thereby controlling output power of the motor. The triac 101 is composed of a semiconductor chip 102 that is disposed in an aluminum case 105. The chip 102 is positioned such that a surface thereof or MT2 terminal (FIG. 6(B)) contacts a bottom surface of the case 105. Conversely, remaining surfaces of the chip 102 are covered by a covering member 103. Further, the triac 101 has an MT1 terminal and a gate (G) terminal. These terminals are connected to conductive parts of a circuit board 104 via lead wires 104. In the switching device, the case 105 may function as a part of the MT2 terminal of the triac 101. Therefore, heat produced from the tip 102 can be directly transmitted to the aluminum case 105. As a result, the triac may have increased heat dissipation characteristics.
Further, the aluminum case 105 is filled with a synthetic resin 106 in order to isolate side surfaces of the case 105 from the triac 101 and the circuit board 104.

In the electrical power tool described above, the MT2 terminal (i.e., a conductive part) of the triac 101 contacts the aluminum case 105. Therefore, if a plurality of switching devices (e.g., FETS) are disposed in the case 105, conductive parts of the switching devices can electrically short-circuited. This means that a plurality of switching devices cannot be disposed in the case 105.

Such an electrical power tool is taught, for example, by Japanese Laid-Open Patent Publication Number 11-77608.

Further, a switching device for a power tool is described in JP 2007-283447.

US 2004/0070946 A1 relates to a power module and production method thereof.

In one aspect of the present invention, an electrical power tool may include a switching device capable of controlling output power of a motor, a circuit board supporting the switching device, and a metal case receiving the circuit board. The switching device includes a conductive part and an insulated portion that is covered by an insulating covering material. The conductive part of the switching device contacts the circuit board. The insulated portion of the switching device contacts the metal case via the insulating covering material.
Further, the metal case is filled with an insulating filling material, so that the circuit board can be embedded therein.

According to this aspect, heat produced from the switching device can be effectively dissipated via conductive parts of the circuit board and the metal case. This may lead to increased heat dissipation characteristics of the switching device.
Further, the conductive part of the switching device can be electrically insulated from the metal case. Therefore, if a plurality of switching devices are attached to the circuit board, conductive parts of the switching devices can be effectively prevented from being electrically short-circuited.

Other objects, features and advantages of the present invention will be readily understood after reading the following detailed description together with the accompanying drawings and the claims.

FIG. 1 is a side view of an electrical power tool according to a representative embodiment of the present invention;
FIG. 2 is a circuit diagram of a DC brushless motor;
FIG. 3 is a sectional view of a case having a circuit board;
FIG. 4 is a bottom plane view of the circuit board;
FIG. 5 is a top plane view of the circuit board;
FIG. 6(A) is a sectional view of a case having a circuit board in a conventional electrical power tool; and
FIG. 6(B) is a diagrammatic sectional view of a triac used in the conventional electrical power tool.

A representative example of the present invention has been described in detail with reference to the attached drawings. This detailed description is merely intended to teach a person of skill in the art further details for practicing preferred aspects of the present invention and is not intended to limit the scope of the invention. Only the claims define the scope of the claimed invention. Therefore, combinations of features and steps disclosed in the foregoing detail description may not be necessary to practice the invention in the broadest sense, and are instead taught merely to particularly describe detailed representative examples of the invention. Moreover, the various features taught in this specification may be combined in ways that are not specifically enumerated in order to obtain additional useful embodiments of the present invention.

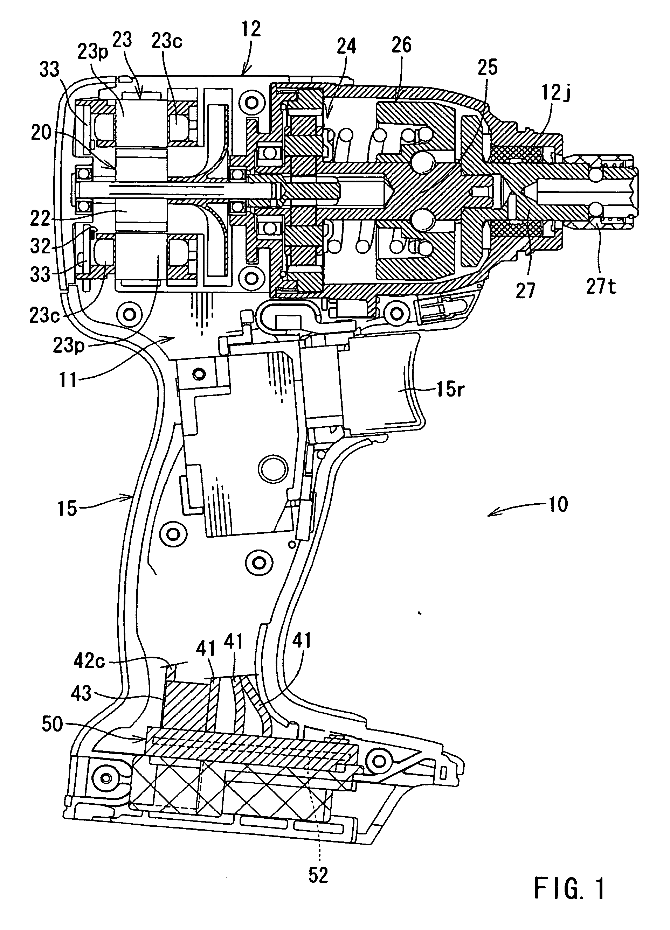

A detailed representative embodiment of the present invention will be described with reference FIGS. 1 to 5. In the embodiment, an electrical impact driver 10 (which will be simply referred to as an impact driver 10) powered by a DC brushless motor 20 is exemplified as an electrical power tool.

As shown in FIG. 1, the impact driver 10 includes a housing 11 that is composed of a hollow main body portion 12 and a grip portion 15 that is extended downwardly from the main body portion 12. The grip portion 15 is provided with a trigger-type switch lever 15r. The switch lever 15r may preferably be positioned such that a user can easily manipulate the switch lever 15r with his/her fingers while gripping the grip portion.

Disposed in the main body portion 12 of the housing 11 are the DC brushless motor 20, a planetary gear mechanism 24, a spindle 25, an impact force generation mechanism 26 and an anvil 27. As shown in FIG. 1, these components are transversely concentrically arranged in this order from the back of the main body portion 12. The DC brushless motor 20 may function as a drive source of the impact driver 10. A rotational speed of the DC brushless motor 20 is reduced by the planetary gear mechanism 24 and is then transmitted to the spindle 25. Upon rotation of the spindle 25, a rotational force is produced. The rotational force produced by the spindle 25 is transmitted to the impact force generation mechanism 26 and is transferred to a rotational impact force by the impact force generation mechanism 26. The rotational impact force is transmitted to the anvil 27. The anvil 27 is rotatably and axially immovably supported via a bearing 12j that is positioned at a forward end of the main body portion 12 of the housing 11. Thus, the anvil 27 can be rotated about an axis by the rotational impact force. Further, a chuck 27t is attached to a distal end of the anvil 27 in order to attach a driver bit, a socket bit or other such bits (not shown) to the anvil 27.

As shown in FIG. 1, the DC brushless motor 20 is composed of a rotor 22 having permanent magnets and a stator 23 having drive coils 23c. The stator 23 may preferably include a cylindrical outer shell portion (not shown) and six tooth members 23p that are radially inwardly projected from the shell portion. The drive coils 23c are respectively attached to the tooth members 23p. The tooth members 23p are positioned circumferentially so as to be equally spaced. Conversely, the rotor 22 is concentrically disposed within the stator 23. Therefore, the tooth members 23p (the drive coils 23c) of the stator 23 are positioned around the rotor 22.

Further, disposed on a rear side of the stator 23 is a magnetic sensor 32 that is capable of detecting rotational positions of magnetic poles of the rotor 22. The magnetic sensor 32 may preferably be attached to the stator 23 via a sensor attachment board 33. Also, the magnetic sensor 32 is electrically connected to a control unit 46 contained in an electrical circuit 40 (which will be described hereinafter). Therefore, the control unit 46 is capable of applying electrical current to the drive coils 23c of the stator 23 in series based upon signals representative of the rotational positions of the magnetic poles of the rotor 22, thereby controllably rotating the rotor 22.

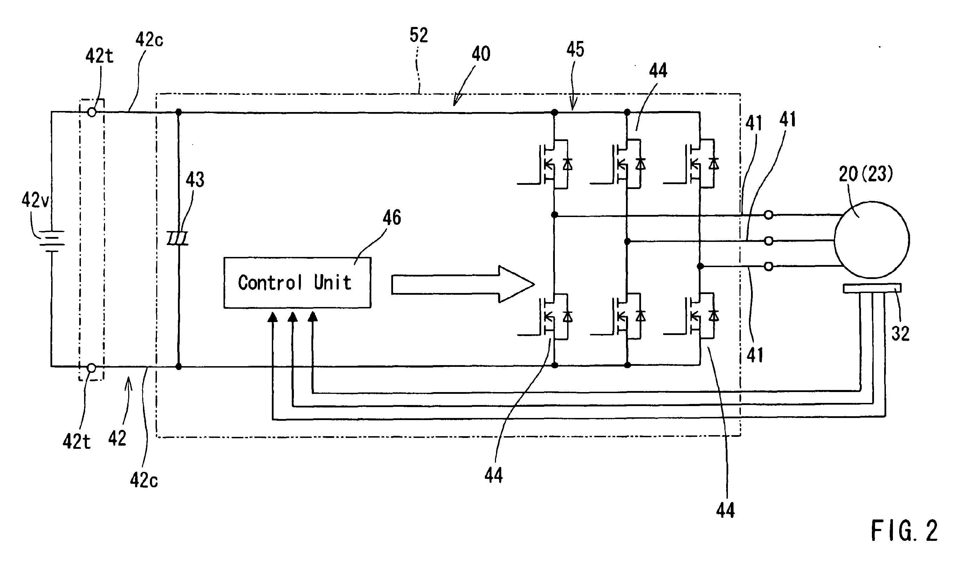

As shown in FIG. 2, the electrical circuit 40 functions to apply electrical current (power) to the DC brushless motor 20. The electrical circuit 40 includes an electrical current source 42 and a three-phase bridge circuit 45 that is composed of six switching devices 44. Further, examples of the switching devices 44 are field-effect transistors (FETS). Also, as previously described, the electrical circuit 40 includes the control unit 46 that is capable of controlling the switching devices 44 of the three-phase bridge circuit 45. The electrical current source 42 may preferably include a battery 42v, electrical cables 42c and a smoothing capacitor 43. The battery 42v is connected to the electrical cables 42c via terminals 42t. The smoothing capacitor 43 is connected to the electrical cables 42c in parallel with the battery 42v.

The three-phase bridge circuit 45 is connected to the electrical cables 42c in parallel with the smoothing capacitor 43. The three-phase bridge circuit 45 has three output cables 41 (which will be referred to as power cables 41). The power cables 41 are respectively connected to the drive coils 23c of the stator 23 of the DC brushless motor 20.

The control unit 46 is electrically communicated with the switching devices 44 of the three-phase bridge circuit 45. Also, as previously described, the control unit 46 is electrically connected to the magnetic sensor 32. Therefore, the control unit 46 is capable of generating on-off signals based upon the signals from the magnetic sensor 32 and transmitting the on-off signals to the switching devices 44 of the three-phase bridge circuit 45, as shown by an outline arrow in FIG. 2. Thus, the electrical current is applied to the drive coils 23c of the stator 23 in series, so that the rotor 22 can be controllably rotated.

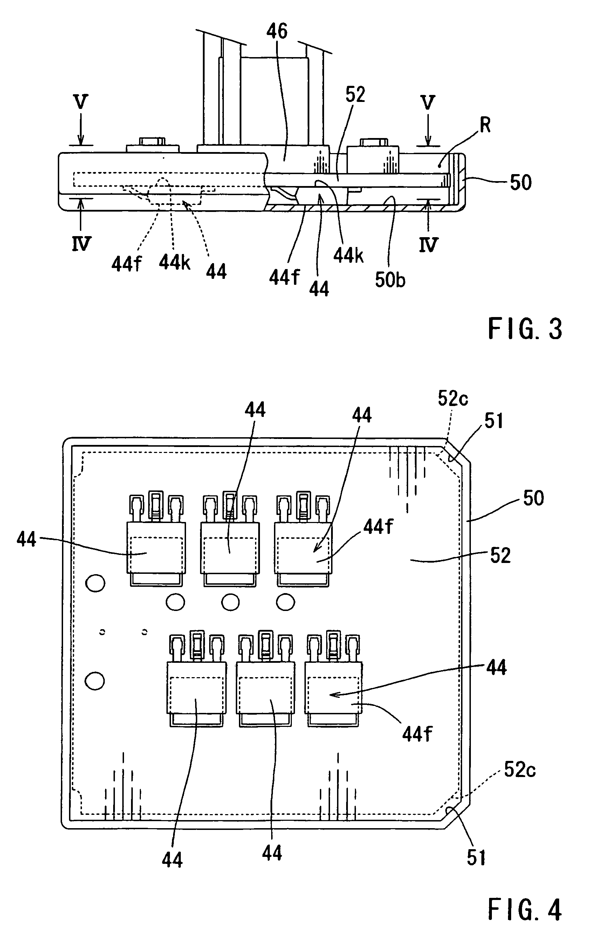

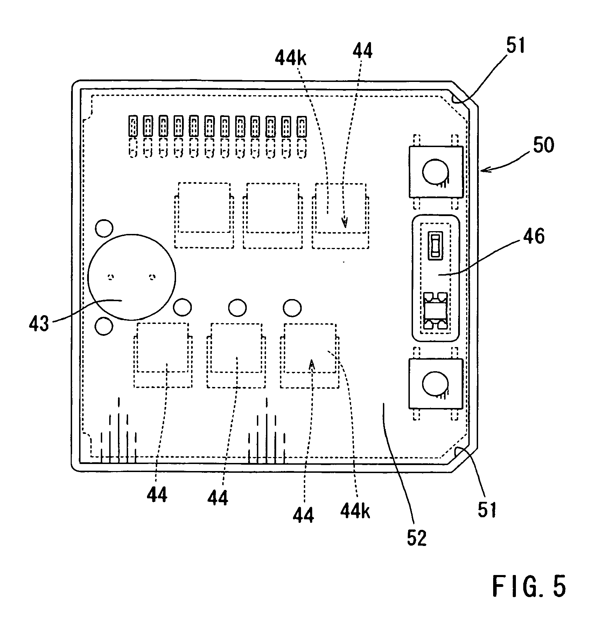

Further, the electrical circuit 40 is formed in a circuit board 52 that is disposed in a case 50 made of aluminum alloy (FIGS. 3-5). In particular, the case 50 is a rectangular open-topped box-shaped (rectangular dish-shaped) container. Conversely, the circuit board 52 has the substantially same shape as the case 50 and is shaped so as to be received in the case 50. As best shown in FIG. 4, the switching devices 44 of the three-phase bridge circuit 45 are attached to a lower side of the circuit board 52. The switching devices 44 are positioned in two rows three by three. Each of the switching devices 44 has a conductive part 44k (a drain terminal) and an insulated portion that is covered by an insulating synthetic resin layer 44f(an insulating covering material). The switching devices 44 are positioned on the rear side of the circuit board 52 such that the conductive part 44k contacts the circuit board 52. Conversely, as best shown in FIG. 5, the smoothing capacitor 43 and the control unit 46 are attached to an upper side of the circuit board 52.

As shown in FIG. 3, the circuit board 52 having the electrical circuit 40 is incorporated into the case 50 such that the switching devices 44 are positioned on a bottom surface 52b of the case 50. Further, the circuit board 52 may preferably positioned so as to be in parallel with the bottom surface 52b of the case 50. At this time, the synthetic resin layers 44f of the switching devices 44 contact the bottom surface 52b of the case 50. In other wards, the switching devices 44 do not electrically contact the bottom surface 52b of the case 50.

Further, as shown in FIGS. 3 and 4, the case 50 may preferably have chamfered portions 51 that are formed in adjacent two corner portions thereof. Conversely, the circuit board 52 may preferably have chamfered portion 52c that are formed in adjacent two corner portions thereof. Therefore, the circuit board 52 can be easily incorporated into the case 50 while the circuit board 52 is correctly oriented.

Further, the case 50 having the circuit board 52 is filled with a thermoplastic insulating resin R (a filling material), so that the circuit board 52 can be embedded therein. Thus, the circuit board 52 can be integrated with the case 50 via the resin R.

As shown in FIG. 1, the case 50 having the circuit board 52 may preferably be disposed on a lower portion of the grip portion 15 of the housing 11.

Thus, in the impact driver 10 of the present embodiment, the conductive parts 44k of the switching devices 44 contact the circuit board 52. Conversely, the insulated portions of the switching devices 44 contact the bottom surface 52b of the case 50 via the synthetic resin layers 44f. Therefore, heat produced from the switching devices 44 can be effectively dissipated via conductive parts of the circuit board 52 and the case 50. This may lead to increased heat dissipation characteristics of the switching devices 44.

Further, the switching devices 44 are electrically insulated from the case 50 via resin layers 44f. That is, the conductive parts 44k of the switching devices 44 are electrically insulated from the case 50. Therefore, the conductive parts 44k of the switching devices 44 can be effectively prevented from being electrically short-circuited. This means that a plurality of switching devices 44 can be disposed in the case 50.

Also, the switching devices 44 can be attached to an entire area of the circuit board 52. Therefore, a large number of switching devices 44 can be attached to the circuit board 52. In addition, the circuit board 52 is combined with the case 50 while the switching devices 44 are interleaved therebetween. As a result, the circuit board 52 can be positioned closer to the case 50. Therefore, thickness of the case 50 can be reduced.

Various changes and modifications may be made to the present invention without departing from the scope of the previously shown and described embodiment. For example, in the embodiment, the case 50 is made of aluminum alloy. However, the case 50 can be made of copper, steel, stainless steel or other such metals.
Further, FETS are exemplified as the switching devices 44. However, the switching devices 44 may be semiconductor devices or other such devices.
Further, in the embodiment, the electrical impact driver 10 is exemplified as the electrical power tool. However, an electrical drill, an electrical disk saw and other such machines can be used as the electrical power tool.
It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. An electrical power tool, comprising
a switching device (44) capable of controlling output power of a motor (20), the switching device (44) including a conductive part (44k) and an insulated portion that is covered by an insulating covering material (44f),
a circuit board (52) supporting the switching device (44), and
a metal case (50) receiving the circuit board (52),
wherein the conductive part (44k) of the switching device (44) contacts the circuit board (52), wherein the insulated portion of the switching device (44) contacts the metal case (50) via the insulating covering material (44f), and wherein the metal case (50) is filled with an insulating filling material (R), so that the circuit board (52) can be embedded therein.

2. The electrical power tool as defined in claim 1, wherein the metal case (50) comprises an open-topped box-shaped container, and wherein the circuit board (52) is positioned so as to be in parallel with a bottom surface of the case (50) while the insulated portion of the switching device (44) contacts the bottom surface of the metal case (50) via the insulating covering material (44f).

3. The electrical power tool as defined in claim 1 or 2, wherein the metal case (50) is made of aluminium alloy.

## Patentansprüche

1. Elektrisches Kraftwerkzeug, mit
einer Schaltvorrichtung (44), die geeignet ist, die Leistungsabgabe eines Motors (20) zu steuern, wobei die Schaltvorrichtung (44) einen leitenden Teil (44k) und einen isolierten Bereich aufweist, der durch ein isolierendes Abdeckmaterial (44f) abgedeckt ist,
einer Platine (52), die die Schaltvorrichtung (44) trägt, und
einem Metallgehäuse (50), das die Platine (52) aufnimmt,
wobei der leitende Teil (44k) der Schaltvorrichtung (44) die Platine (52) berührt, wobei der isolierte Bereich der Schaltvorrichtung (44) das Metallgehäuse (50) über das isolierende Abdeckmaterial (44f) berührt, und wobei das Metallgehäuse (50) mit einem isolierenden Füllmaterial (R) gefüllt ist, so dass die Platine (52) darin eingebettet werden kann.

2. Elektrisches Kraftwerkzeug nach Anspruch 1, wobei das Metallgehäuse (50) einen oben offenen, kastenförmigen Behälter aufweist, und wobei die Platine (52) so angeordnet ist, dass sie parallel zu einer Grundfläche des Metallgehäuses (50) ist während der isolierte Bereich der Schaltvorrichtung (44) die Grundfläche des Metallgehäuses (50) über das isolierende Abdeckmaterial (44f) berührt.

3. Elektrisches Kraftwerkzeug nach Anspruch 1 oder 2, wobei das Metallgehäuse (50) aus einer Aluminiumlegierung hergestellt ist.

## Revendications

1. Outil d'alimentation électrique, comprenant :
un dispositif de commutation (44) capable de commander la puissance de sortie d'un moteur (20), le dispositif de commutation (44) comprenant une partie conductrice (44k) et une portion isolée qui est recouverte par un matériau de recouvrement isolant (44f),
une plaque de circuit (52) supportant le dispositif de commutation (44) et une boîte en métal (50) recevant la plaque de circuit (52),
dans lequel la partie conductrice (44k) du dispositif de commutation (44) est en contact avec la plaque de circuit (52), dans lequel la portion isolée du dispositif de commutation (44) est en contact avec la boîte métallique (50) via le matériau de recouvrement isolant (44f), et dans lequel la boîte métallique (50) est remplie d'un matériau de charge isolant (R), de sorte que la plaque de circuit (52) puisse y être noyée.

2. Outil d'alimentation électrique selon la revendication 1, dans lequel la boîte métallique (50) comprend un récipient en forme de boîte à sommet ouvert et dans lequel la plaque de circuit (52) est positionnée pour pouvoir être parallèle à une surface du fond de la boîte (50), tandis que le portion isolée du dispositif de commutation (44) est en contact avec la surface du fond de la boîte métallique (50) via le matériau de recouvrement isolant (44f).

3. Outil électrique selon la revendication 1 ou 2, dans lequel la boîte métallique (50) est formée d'un alliage d'aluminium.
